# EUROPEAN PATENT APPLICATION

(11) **EP 4 429 414 A1**
(43) Date of publication of application: **11.09.2024**
(21) Application number: 23275040.6
(22) Date of filing: 10.03.2023
(51) Int. Cl.: H05K 1/03, H05K 1/02, H05K 3/00

(54) **PRINTED CIRCUIT BOARD**

(71) Applicant: Hamilton Sundstrand Corporation, Charlotte, NC 28217 (US)
(72) Inventor: PAGE, Andrew Edward, Solihull, B90 4SS (GB); POCOCK, Edward Graham Charles, Solihull, B90 4SS (GB)
(74) Representative: Dehns

(57) **Abstract**

There is provided a printed circuit board 2 comprising a circuit layer 8 comprising an electrical conductor for conducting electricity through the printed circuit board 2 and a support layer 10 for supporting the circuit layer 8. The support layer 10 comprises a fibrereinforced epoxy layer 12 having a thermally conductive and electrically insulating filler powder 14 embedded therein. The support layer 10 has a thermal conductivity of at least 1 W/m. K.

## Description

### Technical Field

This disclosure relates to a printed circuit board, and to a method of manufacturing a printed circuit board.

### Background

Overheating of electronic equipment such as printed circuit board (PCB) assemblies can lead to faults and failures of the equipment. Thermal management is therefore important for maintaining functionality of the equipment. Thermal management becomes increasingly difficult as the overall equipment package is reduced in size and mass.

Currently, the primary method of extracting heat from PCB components is to provide a method of sinking heat to either the equipment chassis or to the atmosphere inside the equipment. In some cases, metallic heat sinks are attached to PCBs near or on hot electrical components to absorb heat from the component and dissipate it to the ambient air. In some cases, electrically-powered cooling components are directly connected to the electrical component to actively increase heat dissipation from the electrical component. For example, a fan can be provided to increase airflow over the electrical component, or the electrical component can be directly connected to a cold plate having a pump for pumping cooling fluid therethrough. These cooling measures typically increase the size, mass and complexity of the PCB assembly which can be undesirable, particularly in applications where space and weight is restricted, or these measures may not be available for the particular application. They can also introduce problems with electronic creep and clearance distances.

The present disclosure aims to provide an improved printed circuit board.

### Summary

According to one aspect of the present disclosure there is provided a printed circuit board comprising: a circuit layer comprising an electrical conductor for conducting electricity through the printed circuit board; and a support layer for supporting the circuit layer; wherein the support layer comprises a fibre-reinforced epoxy layer having a thermally conductive and electrically insulating filler powder embedded therein, the support layer having a thermal conductivity of at least 1 W/m.K.

In an optional example, the filler powder comprises a ceramic powder. The ceramic powder may for example comprise boron nitride or aluminium nitride.

Optionally, the circuit layer comprises copper. Other metals such as iron and/or aluminium may be present in the circuit layer.

In an optional example, the printed circuit board is a multi-layer printed circuit board. The multi-layer printed circuit board may comprise a plurality of circuit layers and a plurality of support layers arranged in an alternating arrangement. In an optional example, the multi-layer printed circuit board may comprise at least four circuit layers and at least four support layers.

The support layer may optionally comprise a glass reinforced epoxy laminate sheet. In an optional example, the glass reinforced epoxy laminate sheet comprises FR4 as defined in the NEMA LI 1-1998 standard.

Optionally, a volumetric ratio of filler powder in the fibre-reinforced epoxy layer may be in the range of 5% to 50%. The volumetric ratio of filler powder may be in the range of 10% to 40% or in the range of 15% to 30%.

Optionally, the thermal conductivity of the support layer may be at least 5 W/m.K.

An aspect of the present disclosure provides an assembly comprising: a printed circuit board as described herein; and an electrical component arranged on a first side of the printed circuit board and electrically connected to the circuit layer, wherein in use the electrical component has an average thermal loss in the range of 5 W to 50 W.

Optionally, a second side of the printed circuit board, which is opposite to the first side, comprises cooling fins configured to exchange heat with ambient air.

Optionally, at least 50% of the heat generated by the electrical component is dissipated through the printed circuit board.

In an optional example, the assembly does not comprise an electrically-powered cooling component directly connected to the electrical component to actively increase heat dissipation from the electrical component, such as a fan or a cold plate having a pump for pumping cooling fluid therethrough.

Optionally, the assembly does not comprise a metallic heat sink abutting the electrical component.

Optionally, the component is an electronic component, for example an electronic controller.

An aspect of the present disclosure provides a method of manufacturing a printed circuit board, comprising: mixing epoxy with a thermally conductive and electrically insulating filler powder; applying the epoxy and filler powder mixture to a fibre structure; curing the epoxy to form a support layer of the printed circuit board, the support layer having a thermal conductivity of at least 1 W/m.k; and adding a circuit layer comprising an electrical conductor to the support layer.

In an optional example, the method comprises arranging a plurality of circuit layers and a plurality of support layers in an alternating stacked arrangement and bonding the stacked arrangement to form a multi-layer printed circuit board.

Optionally, the method comprises electrically connecting an electrical component on a first side of the printed circuit board, wherein in use the electrical component has an average thermal loss in the range of 5 W to 50 W.

Optionally, the method is a method of manufacturing a printed circuit board as described herein. The printed circuit board may have any of the features described above.

### Brief description of drawings

Certain embodiments of the disclosure will now be described, by way of example only, and with reference to the accompanying drawings.
Figure 1 shows a cross-sectional view of a single-layer printed circuit board;
Figure 2 shows a cross-sectional view of a multi-layer printed circuit board; and
Figure 3 shows thermal plots of three printed circuit boards having different heat transfer coefficients.

### Detailed description

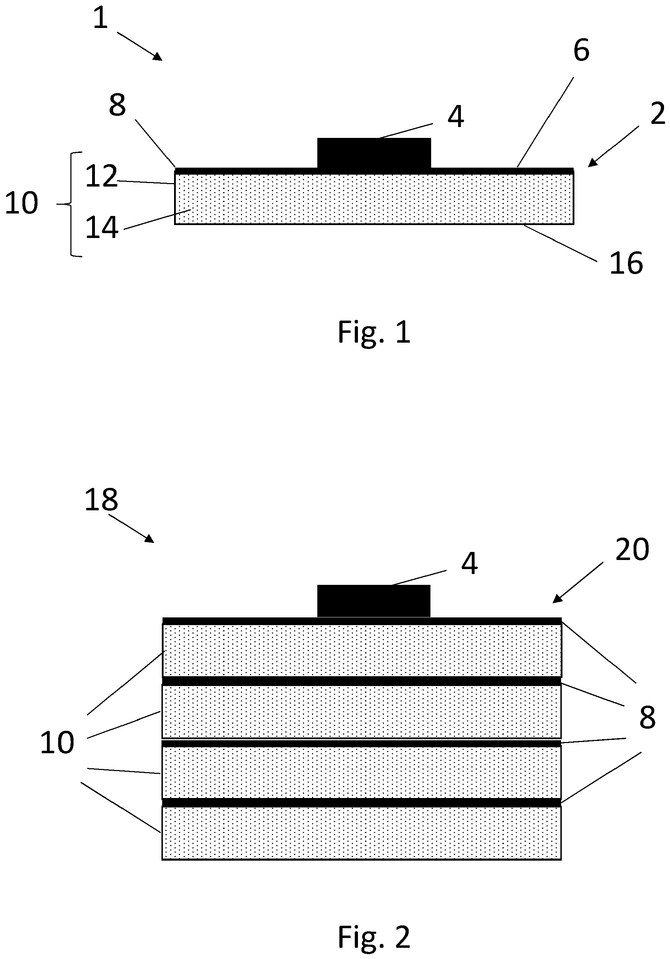

Figure 1 shows a schematic diagram of a printed circuit board (PCB) assembly 1 comprising a printed circuit board 2 and an electrical component 4 arranged on a first side 6 of the printed circuit board 2. As used herein, the term 'printed circuit board' is intended to encompass printed wiring boards (PWBs).

The printed circuit board 2 comprises a circuit layer 8 and a support layer 10. In some embodiments other layers may be present, such as one or more solder mask layers and/or a silkscreen layer (not shown).

The circuit layer 8 comprises an electrical conductor for conducting electricity through the printed circuit board 2. In some embodiments the circuit layer 8 comprises copper, such as an etched copper sheet. Other metals may be present such as iron and/or aluminium. The electrical component 4 is electrically connected to the circuit layer 8, for example soldered thereto.

The support layer 10 is for supporting the circuit layer 8. The support layer 10 comprises a fibre-reinforced epoxy layer 12 having a thermally conductive and electrically insulating filler powder 14 embedded therein. The support layer 10 has a thermal conductivity of at least 1 W/m.K. In some embodiments the thermal conductivity of the support layer 10 may be at least 5 W/m.K.

The filler powder 14 has a higher thermal conductivity than the epoxy and the fibre reinforcement. The presence of the filler powder 14 in the fibre-reinforced epoxy layer 12 advantageously increases the thermal conductivity of the PCB 2. A thermally conductive PCB 2 can act as a heatsink, thus allowing heat generated by the electrical component 4 to sink into the PCB 2. Additionally, it will allow heat to dissipate via the PCB 2 to a further heat sink, such as a chassis (not shown) containing the PCB assembly 1, where it can be further dissipated e.g. to an external structure or to ambient air.

Since the filler powder 14 is integrated within the PCB structure itself, the thermal management of the PCB assembly 1 is improved without significantly increasing the PCB 2 mass or volume. The need for a metallic heatsink or an active cooling component may be reduced or eliminated. Therefore, in some embodiments the PCB assembly 1 does not comprise an electrically-powered cooling component directly connected to the electrical component 4 arranged to actively increase heat dissipation from the electrical component 4, such as a fan or a cold plate having a pump for pumping cooling fluid therethrough. Also, in some embodiments the PCB assembly 1 does not comprise a metallic heat sink abutting the electrical component 4. In other embodiments one or more of these cooling components may be used in combination with the printed circuit board 2 disclosed herein to provide enhanced cooling through a combination of cooling methods.

In some embodiments, the PCB assembly 1 comprises one or more passive cooling features for passively (i.e. without the use of electrically-powered components) increasing heat exchange with a surrounding environment, such as ambient air. In one example, not shown, a second side 16 of the printed circuit board 2 comprises cooling fins configured to exchange heat with ambient air. The second side 16 may be an opposing plane of the PCB 2. For example the first side 6 may be an uppermost side of the PCB 2 and the second side 16 may be the lowermost side of the PCB 2. This is beneficial because the thermally conductive PCB 2 can absorb heat from the first side 6, where the hot electrical component 4 is arranged, and transmit the heat by conduction to the second side 16, where it can be dissipated to ambient air with the aid of the cooling fins and/or other passive cooling features. Optionally, powered cooling features may be used on the second side 16.

The filler powder 14 may comprise a ceramic powder. For example, the filler powder 14 may comprise boron nitride or aluminium nitride. In a specific example, the filler powder 14 may comprise 3M^{™} Boron Nitride Cooling Filler. Advantages of using ceramic powder as the filler powder 14 include that ceramic powders typically have relatively high thermal conductivity, whilst retaining a low electrical conductivity. Therefore the support layer 10 remains sufficiently electrically insulating compared to the electrically conducting circuit layer 8.

The fibre-reinforced epoxy layer 12 may comprise a glass reinforced epoxy laminate sheet. In a specific example, the fibre-reinforced epoxy layer 12 comprises FR4 as defined in the NEMA LI 1-1998 standard.

The amount of filler powder 14 embedded in the fibre-reinforced epoxy can be selected to achieve a desired thermal conductivity. In general, a lower amount of filler powder 14 will result in a lower thermal conductivity whereas a higher amount of filler powder 14 will result in a higher thermal conductivity. However, an excess of filler powder 14 may make manufacturability of the support layer 10 more difficult and may affect the structural integrity of the support layer 10. Therefore, the amount of filler powder 14 is ideally selected to balance these parameters.

In some embodiments, a volumetric ratio of filler powder 14 in the fibre-reinforced epoxy layer 12 is in the range of 5% to 50%. In an example using a boron nitride as the filler powder 14 and FR4 as the fibre-reinforced epoxy layer 12, a volumetric ratio of filler powder 14 in this range results in a thermal conductivity of around 1.5 to 15 W/m.K. By comparison, the approximate thermal conductivity of FR4 without addition of a thermally conductive filler powder 14 is 0.35 W/m.K. Therefore, with a volumetric ratio of filler powder 14 in this range, thermal conductivity increases can be achieved without adversely affecting the structural integrity of the support layer 10.

The PCB assembly 1 of Figure 1 comprises a single-layer PCB 2 having only one circuit layer 8 and one support layer 10. In other embodiments a plurality of circuit layers 8 and a plurality of support layers 10 can be provided, as described below with reference to Figure 2.

The PCB assembly 1 may comprise a plurality of electrical components 4 having the features of the electrical component 4 described above.

Figure 2 shows a schematic diagram of a printed circuit board assembly 18 comprising a multi-layer PCB 20 comprising a plurality of circuit layers 8 and a plurality of support layers 10, and an electrical component 4 electrically connected to at least one of the circuit layers 8. Each circuit layer 8 and each support layer 10 may have a structure as the corresponding layers described in relation to the PCB assembly 1 of Figure 1.

In the example shown in Figure 2, there are four circuit layers 8 and four support layers 10. However, more or fewer circuit layers 8 and/or support layers 10 may be provided. Other layers may be present as well. Including a plurality of layers 8, 10 allows more complex electrical connections within the PCB 20 to be formed.

The PCB assemblies 2, 18 shown in Figures 1 or 2 may be particularly useful in applications in which the electrical component(s) 4 of the PCB assembly 2, 18 experience thermal output levels which are high enough to risk heat-related malfunctions, but not so hot as to warrant the inclusion of a heavy and bulky active cooling component (such as a fan or cooling plate described previously) or where active cooling is not available. For example, the PCB assembly 2, 18 may be a part of a controller for an electric motor.

Therefore, the electrical component 4 may have an average thermal loss in the range of 5 W to 50 W when in use, i.e. when the electrical component 4 is connected to a power source. The average thermal loss may comprise a measurement of the thermal loss of the electrical component 4 averaged over time while the printed circuit board assembly 2, 18 is operating normally, e.g. without any faults and within its intended design parameters such as the intended input voltage and current. It will be appreciated that the PCB assemblies 2, 18 may also be used with electrical components having average thermal loss above or below this range.

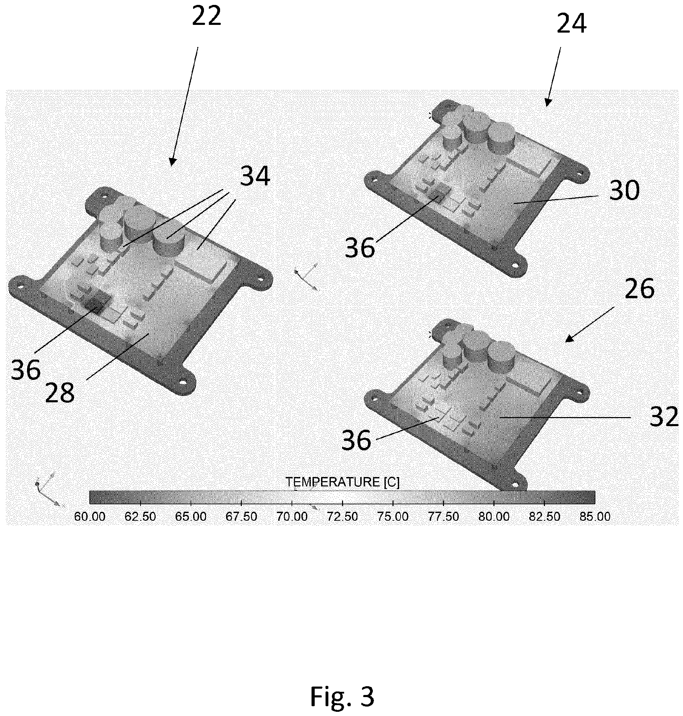

Figure 3 shows thermal plots of three PCB assemblies 22, 24, 26 having PCBs 28, 30, 32 with different heat transfer coefficients (i.e. thermal conductivities).

Each of the three PCB assemblies 22, 24, 26 comprises the same electrical components 34, 36 and is subject to the same operational parameters. The only difference is in the thermal conductivity of each PCB 22, 24, 26 to which the electrical components 34, 36 are electrically connected.

The thermal plot on the left hand side shows a PCB assembly 22 comprising a PCB 28 having a thermal conductivity of 0.35W/m.K. The PCB 28 comprises an FR4 layer and a circuit layer, and various electrical components 34, 36 are electrically connected to the circuit layer.

During operation of the PCB assembly 22, the temperature of the PCB assembly 22 increases to an average of 71.97°C and a maximum of 85.14°C. In particular, one electrical component 36 becomes hotter than the other components, shown by the concentrated darker shading of the thermal plot in the region including and directly surrounding the component 36.

The thermal plot on the upper right hand side shows a PCB assembly 24 comprising a PCB 30 having a thermal conductivity of 1W/m.K. The PCB 30 comprises a circuit layer and an FR4 layer with a boron nitride filler embedded therein. The same electrical components 34, 36 as in the PCB assembly 22 are electrically connected to the circuit layer.

During operation of the PCB assembly 24, the temperature of the PCB assembly 24 increases to an average of 71.01 °C and a maximum of 81.44°C. The one electrical component 36 is still hotter than the other components, shown by the concentrated darker shading of the thermal plot in the region including and directly surrounding the component 36, but it reaches a lower maximum temperature than the same component 36 in the PCB assembly 22 due to the increased thermal conductivity of the PCB 30 compared to the PCB 28. Therefore, the thermal management of the PCB assembly 24 is improved.

The thermal plot on the lower right hand side shows a PCB assembly 26 comprising a PCB 32 having a thermal conductivity of 15W/m.K. The PCB 32 comprises a circuit layer and an FR4 layer with a boron nitride filler embedded therein at a higher volumetric ratio than the PCB 30 of PCB assembly 24. The same electrical components 34, 36 are electrically connected to the circuit layer.

During operation of the PCB assembly 26, the temperature of the PCB assembly 26 increases to an average of 68.53°C and a maximum of 73.34°C. The electrical component 36 is at approximately the same temperature as other regions of the PCB 32 due to the increased thermal conductivity of the PCB 30 compared to the PCB 28. Therefore, the thermal management of the PCB assembly 24 is further improved.

It can therefore be seen that a PCB assembly having a PCB with a higher thermal conductivity has a decreased average temperature and maximum temperature. Furthermore, when the PCB thermal conductivity is higher, the heat is more evenly distributed across the PCB and less concentrated around hot electrical components such as component 36 shown in the plots.

The described PCB assemblies 1, 18 therefore offer at least the following potential benefits:
- Improved thermal management of PCB assemblies.
- Reduced assembly complexity due to the removal of the need for heatsinks or active cooling components.
- Reduced equipment mass due to the removal of the need for heatsinks or active cooling components.
- Improved PCB space utilisation due to removal of heatsink pads, and lower thermal spacing of components.
- Improved operating temperature range due to reduced self-heating effect.

## Claims

1. A printed circuit board comprising:
a circuit layer comprising an electrical conductor for conducting electricity through the printed circuit board; and
a support layer for supporting the circuit layer;
wherein the support layer comprises a fibre-reinforced epoxy layer having a thermally conductive and electrically insulating filler powder embedded therein, the support layer having a thermal conductivity of at least 1 W/m.K.

2. A printed circuit board as claimed in claim 1, wherein the filler powder comprises a ceramic powder, optionally boron nitride or aluminium nitride.

3. A printed circuit board as claimed in claim 1 or 2, wherein the circuit layer comprises copper.

4. A printed circuit board as claimed in claim 1, 2 or 3, wherein the printed circuit board is a multi-layer printed circuit board comprising a plurality of circuit layers and a plurality of support layers arranged in an alternating arrangement.

5. A printed circuit board as claimed in any preceding claim, wherein the support layer comprises a glass reinforced epoxy laminate sheet, optionally FR4 as defined in the NEMA LI 1-1998 standard.

6. A printed circuit board as claimed in any preceding claim, wherein a volumetric ratio of filler powder in the fibre-reinforced epoxy layer is in the range of 5% to 50%.

7. A printed circuit board as claimed in any preceding claim, wherein the thermal conductivity of the support layer is at least 5 W/m.K.

8. An assembly comprising:
a printed circuit board as claimed in any preceding claim; and
an electrical component arranged on a first side of the printed circuit board and electrically connected to the circuit layer,
wherein in use the electrical component has an average thermal loss in the range of 5 W to 50 W.

9. An assembly as claimed in claim 8, wherein a second side of the printed circuit board, which is opposite to the first side, comprises cooling fins configured to exchange heat with ambient air.

10. An assembly as claimed in claim 8 or 9, wherein at least 50% of the heat generated by the electrical component is dissipated through the printed circuit board.

11. An assembly as claimed in claim 8, 9 or 10, wherein the assembly does not comprise:
an electrically-powered cooling component directly connected to the electrical component to actively increase heat dissipation from the electrical component, such as a fan or a cold plate having a pump for pumping cooling fluid therethrough; and/or
a metallic heat sink abutting the electrical component.

12. An assembly as claimed in any of claims 8 to 11, wherein the component is an electronic component, optionally an electronic controller.

13. A method of manufacturing a printed circuit board, comprising:
mixing epoxy with a thermally conductive and electrically insulating filler powder;
applying the epoxy and filler powder mixture to a fibre reinforcement structure;
curing the epoxy to form a support layer of the printed circuit board, the support layer having a thermal conductivity of at least 1 W/m.k; and
adding a circuit layer comprising an electrical conductor to the support layer.

14. A method as claimed in claim 13, comprising arranging a plurality of circuit layers and a plurality of support layers in an alternating stacked arrangement and bonding the stacked arrangement to form a multi-layer printed circuit board.

15. A method as claimed in claim 13 or 14, comprising electrically connecting an electrical component on a first side of the printed circuit board, wherein in use the electrical component has an average thermal loss in the range of 5 W to 50 W.
